(19) Europäisches Patentamt
European Patent Office
Office européen des brevets

(11) **EP 0 891 044 B1**

(12) **EUROPÄISCHE PATENTSCHRIFT**

(45) Veröffentlichungstag und Bekanntmachung des Hinweises auf die Patenterteilung:
**28.03.2001 Patentblatt 2001/13**

(51) Int Cl.⁷: **H03K 17/94**

(21) Anmeldenummer: **98112187.4**

(22) Anmeldetag: **01.07.1998**

(54) **Verfahren zum Betrieb eines optoelektronischen Sensors**

Method for controlling an optoelectronic sensor

Procédé pour la commande d'un dispositif détecteur optoélectrique

(84) Benannte Vertragsstaaten:
**CH DE FR IT LI**

(30) Priorität: **10.07.1997 DE 19729638**

(43) Veröffentlichungstag der Anmeldung:
**13.01.1999 Patentblatt 1999/02**

(73) Patentinhaber: **SICK AG**
**79183 Waldkirch (DE)**

(72) Erfinder:
• **Blümcke, Thomas**
**79261 Gutach (DE)**
• **Kietz, Daniel**
**79642 Riegel (DE)**
• **Waslowski, Kai**
**79312 Emmendingen (DE)**

(74) Vertreter: **Finsterwald, Martin et al**
**Manitz, Finsterwald & Partner,**
**Robert-Koch-Strasse 1**
**80538 München (DE)**

(56) Entgegenhaltungen:
**EP-A- 0 485 857**         **EP-A- 0 531 646**
**DE-A- 4 207 772**         **DE-U- 9 010 998**

**Beschreibung**

Die Erfindung betrifft ein Verfahren zum Betrieb eines opto-elektronischen Sensors, insbesondere einer Lichtschranke, bei dem mittels eines Lichtsenders ein Lichtsignal in einen Überwachungsbereich ausgesandt wird und ein zum Empfang von ausgesandten und reflektierten Lichtsignalen ausgelegter Lichtempfänger ein Empfangssignal liefert, dessen Amplitude auf Vorhandensein eines Objekts im Überwachungsbereich untersucht wird, wobei bei Über- oder Unterschreitung eines Erkennungs-Schwellwerts ein Gegenstands-Feststellungssignal abgegeben wird. Ein derartiges Verfahren ist aus EP-A-0 485 857 bekannt.

Für das zufriedenstellende Funktionieren derartiger Verfahren ist es wesentlich, daß der genannte Erkennungs-Schwellwert korrekt eingestellt ist, da bei einer unzureichenden Einstellung des Erkennungs-Schwellwerts nicht ausgeschlossen werden kann, daß ein Gegenstands-feststellungssignal abgegeben wird, obwohl kein Objekt im Überwachungsbereich vorhanden ist oder daß kein Gegenstandsfeststellungssignal abgegeben wird, obwohl ein Objekt im Überwachungsbereich vorhanden ist.

Zur Einstellung des Erkennungs-Schwellwerts ist es bekannt, diesen beispielsweise mittels eines Potentiometers manuell vom Benutzer auf einen geeigneten Wert einstellen zu lassen, wobei ein derartiges manuelles Verfahren naturgemäß mit Ungenauigkeiten behaftet ist.

Weiterhin ist es zumindest gemäß internem Stand der Technik der Anmelderin bekannt, Teach-In-Verfahren einzusetzen, bei denen in den Überwachungsbereich des opto-elektronischen Sensors ein Objekt eingebracht, die dabei empfangene Signalamplitude mit einem Faktor bewertet und gespeichert und dieser gespeicherte Wert als künftiger Erkennungs-Schwellwert verwendet wird.

Letztgenanntes Verfahren besitzt den Nachteil, daß der Aufwand des Einbringens des Objektes in den Überwachungsbereich betrieben werden muß und aufgrund verschiedener Eigenschaften der eingebrachten Objekte, insbesondere aufgrund verschiedener Reflektivitäten, verschiedener Abstände zum Sensor sowie verschiedener geometrischer Formen der Objekte nicht sichergestellt werden kann, daß man im Rahmen des Teach-In-Verfahrens immer den für die Einstellung des Erkennungs-Schwellwerts maßgeblichen Fall erfaßt.

Weiterhin ist es von Nachteil, daß ein einmal festgelegter Erkennungs-Schwellwert während der Betriebszeit des Sensors konstant bleibt und somit betriebsbedingten Lichtleistungsschwankungen, die beispielsweise durch Verschmutzung oder Alterung der Lichtsender bedingt sind, nicht Rechnung tragen kann, so daß es zu Fehlerkennungen von Objekten im Überwachungsbereich kommt.

Eine Aufgabe der Erfindung besteht darin, ein Verfahren der eingangs genannten Art derart zu verbessern, daß eine möglichst exakte und den tatsächlich gegebenen Betriebsbedingungen Rechnung tragende Festlegung des Erkennungs-Schwellwerts zum Betriebsbeginn möglich wird und/oder daß auch während des Betriebs des Sensors auftretende Lichtleistungs- oder Systemempfindlichkeitsschwankungen auf geeignete Weise kompensiert werden können.

Zur Lösung der genannten Aufgaben wird erfindungsgemäß vorgeschlagen, daß mehrere Schalt-Schwellwerte vorgegeben werden, wobei das Über- bzw. Unterschreiten dieser Schalt-Schwellwerte durch das Empfangssignal jeweils ein Schaltsignal auslöst, daß die Anzahl der bezüglich jedes Schalt-Schwellwerts auftretenden Schaltsignale ermittelt wird, und daß der Erkennungs-Schwellwert und die Schalt-Schwellwerte in Abhängigkeit von den ermittelten Anzahlen ein- oder nachgestellt werden.

Die Erfindung macht sich die Erkenntnis zunutze, daß sich die Amplitude des Empfangssignals sowohl beim Vorhandensein von Objekten im Überwachungsbereich als auch bei objektfreiem Überwachungsbereich innerhalb bestimmter Bereiche bewegt. Dadurch, daß die erfindungsgemäß vorgesehenen Schalt-Schwellwerte in diese Bereiche und/oder etwas ober- oder unterhalb dieser Bereiche gelegt werden, kann überprüft werden, ob sich das Empfangssignal in den jeweiligen Betriebssituationen in den erwarteten Bereichen bewegt. Diese Überprüfung erfolgt erfindungsgemäß, in dem gezählt wird, wie oft jeder der definierten Schalt-Schwellwerte vom Empfangssignal über- bzw. unterschritten wird. Es können hierbei beispielsweise Schalt-Schwellwerte definiert werden, die bei einem ordnungsgemäßen Funktionieren des erfindungsgemäßen Sensors niemals über- bzw. unterschritten werden. Weiterhin ist es möglich, zwei Schalt-Schwellwerte so zu definieren, daß sie bei einem ordnungsgemäßen Funktionieren des erfindungsgemäßen Sensors grundsätzlich immer nur gemeinsam über- bzw. unterschritten werden. Wenn dann beispielsweise beim Betrieb des erfindungsgemäßen Sensors der erstgenannte Schalt-Schwellwert über- bzw. unterschritten wird oder von den beiden letztgenannten Schalt-Schwellwerten nur einer über- bzw. unterschritten wird, kann darauf geschlossen werden, daß die Schalt-Schwellwerte nachgestellt werden müssen.

Gemeinsam mit den Schalt-Schwellwerten ist dann auch der Erkennungs-Schwellwert, welcher für die Abgabe eines Gegenstands-Feststellungssignals verantwortlich ist, neu festzulegen, wobei diese Festlegung in Abhängigkeit von den neu eingestellten Schalt-Schwellwerten erfolgt. Zu diesem Zweck kann der Erkennungs-Schwellwert beispielsweise derart definiert sein, daß er immer gleich einem mit einem vorgegebenen Faktor multiplizierten Schalt-Schwellwert ist. Ebenso ist es möglich, einen der Schalt-Schwellwerte direkt als Erkennungs-Schwellwert zu definieren.

Bevorzugt ist es, wenn ein Schalt-Schwellwert der Amplitude des Empfangssignals bei objektfreiem Überwachungsbereich entspricht. Falls das erfindungsgemäße Verfahren bei einer Reflex-Lichtschranke eingesetzt wird, kann dieser Schalt-Schwellwert die höchste Amplitude aller vorgesehenen Schalt-Schwellwerte aufweisen. Dieser Schalt-Schwellwert kann dabei auch einem etwas oberhalb der Amplitude des Empfangssignals bei objektfreiem Überwachungsbereich angesiedelten Wert entsprechen.

Von Vorteil ist es, wenn all diejenigen Schalt-Schwellwerte, welche nicht der Amplitude des Empfangssignals bei objektfreiem Überwachungsbereich entsprechen, jeweils einem vorgegebenen Prozentsatz des genannten Schalt-Schwellwerts entsprechen. Diese Prozentsätze liegen bei einer Reflex-Lichtschranke unter 100 %. Somit stehen alle Schalt-Schwellwerte unabhängig von der momentanen konkreten Einstellung in einem konstanten Verhältnis zueinander.

Besonders vorteilhaft ist es, wenn vor Inbetriebnahme des Sensors im Rahmen eines Initialisierungsprozesses bei objektfreiem Überwachungsbereich derjenige Schalt-Schwellwert ermittelt wird, dessen Amplitude dem Empfangssignal bei objektfreiem Überwachungsbereich entspricht, wobei die anderen Schalt-Schwellwerte in Abhängigkeit von dem genannten Schalt-Schwellwert berechnet werden, wodurch alle Schalt-Schwellwerte an die während des Initialisierungsprozesses gegebenen Betriebsbedingungen angepaßt werden. Da der Erkennungs-Schwellwert - wie bereits erläutert - in Abhängigkeit von den Schalt-Schwellwerten festgelegt wird, kann auf die genannte Weise sichergestellt werden, daß der Erkennungs-Schwellwert unmittelbar nach dem Initialisierungsprozeß optimal an die gegebenen Betriebsbedingungen angepaßt ist, wodurch das Risiko für Fehlerkennungen deutlich reduziert wird. Zudem ist es erfindungsgemäß möglich, den Initialisierungsprozeß durchzuführen, ohne ein Objekt in den Überwachungsbereich einbringen zu müssen.

Während des Betriebs eines Sensors ist es gemäß der Erfindung vorteilhaft, wenn die ermittelten und jeweils auf die Schalt-Schwellwerte bezogenen Anzahlen der Schaltsignale in Beziehung zueinander oder zu einem vorgegebenen Wert gesetzt und die jeweils gültigen Ist-Beziehungen mit vorgegebenen Soll-Beziehungen verglichen werden, wobei ein Nachstellen der Schalt-Schwellwerte und des Erkennungs-Schwellwertes nur bei einer Abweichung der Ist-Beziehungen von den Soll-Beziehungen erfolgt. In diesem Fall paßt sich der erfindungsgemäß betriebene Sensor während seines Betriebs automatisch an veränderte Betriebsbedingungen an, die beispielsweise durch Temperatur- oder Verschmutzungseffekte hervorgerufen werden.

Die Schalt-Schwellwerte werden im Rahmen eines Nachstell-Vorgangs bevorzugt so eingestellt, daß die Verhältnisse der Schalt-Schwellwerte zueinander immer konstant bleiben. Dies bedeutet, daß durch einen Nachstell-vorgang beispielsweise mittels eines Regelalgorithmus ein neuer Wert für den höchsten Schalt-Schwellwert berechnet wird, woraufhin alle anderen Schalt-Schwellwerte sowie der Erkennungs-Schwellwert auf neue Werte eingestellt werden, die jeweils einem fest vorgegebenen Prozentsatz des genannten neu justierten Schalt-Schwellwerts entsprechen.

Die auf die Schalt-Schwellwerte bezogenen Anzahlen können jeweils für die Dauer einer vorgegebenen Betriebszeitspanne ermittelt werden, an deren Ende gegebenenfalls ein Nachstellen erfolgt. Das Nachstellen kann während des Sensorbetriebs in einem konstanten Zeitraster wiederholt werden.

Bevorzugt ist es, wenn insgesamt 3 oder 4 unterschiedliche Schalt-Schwellwerte vorgegeben werden, wobei beispielsweise einer dieser Schalt-Schwellwerte als Erkennungs-Schwellwert definiert wird.

Vorteilhaft ist es, wenn der Lichtsender eines erfindungsgemäß arbeitenden Sensors mit Pulslicht betrieben wird.

Die Erfindung kann bei einer Reflex-Lichtschranke eingesetzt werden, bei der die ausgesandten Lichtsignale bei objektfreiem Überwachungsbereich von einem am dem Sensor gegenüberliegenden Ende des Überwachungsbereichs angeordneten Reflektor zum Lichtempfänger reflektiert werden. Ebenso ist es jedoch auch möglich, die Erfindung beim Betrieb einer Einweg-Lichtschranke einzusetzen.

Das erfindungsgemäße Verfahren ist bevorzugt zur Klarglaserkennung einsetzbar, was im Rahmen der nachfolgenden Figurenbeschreibung noch näher erläutert wird.

Weitere bevorzugte Ausführungsformen der Erfindung sind in den Unteransprüchen angegeben.

Die Erfindung wird nachfolgend anhand eines Ausführungsbeispiels unter Bezugnahme auf die Zeichnungen beschrieben; in diesen zeigen:

Fig. 1    den Verlauf eines Empfangssignals mit korrekt eingestellten Schalt-Schwellwerten und korrekt eingestelltem Erkennungs-Schwellwert,

Fig. 2    den Verlauf eines Empfangssignals mit zu niedrig eingestellten Schalt-Schwellwerten und zu niedrig eingestelltem Erkennungs-Schwellwert,

Fig. 3    den Verlauf eines Empfangssignals mit zu hoch eingestellten Schalt-Schwellwerten und zu hoch eingestelltem Erkennungs-Schwellwert,

Fig. 4    den Verlauf eines Empfangssignals in einem Betriebsfall, in dem ein Gegenstandsfeststellungssignal nicht zuverlässig erzeugt werden kann.

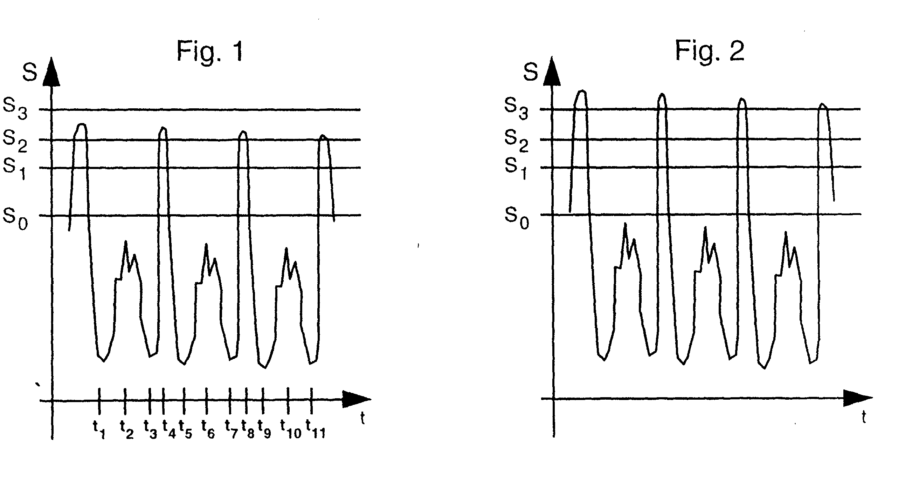

Die Fig. 1 - 4 zeigen Empfangssignalverläufe eines erfindungsgemäß betriebenen Sensors, welcher Pulslicht in Richtung eines Reflektors aussendet und das reflektierte Pulslicht mit einer Photodiode empfängt und dessen Amplitude digitalisiert. Der zeitliche Verlauf dieser digitalisierten Amplituden ist in den Fig. 1 - 4 dargestellt.

Gemäß den Fig. 1 - 4 wird der Sensor zur Erkennung von Glasflaschen eingesetzt, welche durch den Überwachungsbereich des Sensors transportiert werden. Charakteristisch für durchscheinende Glasflaschen, insbesondere Klarglasflaschen ist, daß das im Bereich der Flaschenränder durch die Flasche tretende Licht stärker abgeschwächt wird als das durch den zwischen den Rändern liegenden Bereich tretende Licht, da die Dämpfung des Lichtes im Bereich der Flaschenränder durch Absorption, Reflexion und/oder Brechung größer ist als in dem zwischen den Flaschenrändern liegenden Bereich. Wenn also eine solche Glasflasche an einem als Reflektions-Lichtschranke ausgebildeten optischen Sensor vorbeibewegt wird, ergibt sich durch den zuerst in den Überwachungsbereich bewegten Flaschenrand eine relativ starke Abschwächung des vom Sensor ausgesandten Lichtsignals, woraufhin dann eine geringere Abschwächung auftritt, wenn der zwischen den Flaschenrändern liegende Bereich in den Überwachungsbereich bewegt wird. Wenn schließlich nachfolgend der zweite, in Förderrichtung hinten liegende Flaschenrand in den Überwachungsbereich bewegt wird, ergibt sich wiederum eine starke Abschwächung des vom Sensor ausgesandten Lichtsignals. Für jede durch den Überwachungsbereich bewegte Flasche wird somit ein im wesentlichen W-förmiger Empfangssignalverlauf erhalten, wie dieser beispielsweise in Fig. 1 für drei aufeinanderfolgende Flaschen dargestellt ist.

Der erste Flaschenrand der ersten Flasche führt zum Zeitpunkt $t_1$ zu einem Abfall des in Fig. 1 dargestellten Empfangssignals, woraufhin der zwischen den Flaschenrändern liegende Bereich zum Zeitpunkt $t_2$ zu einem Ansteigen des Empfangssignals führt. Der in Förderrichtung nachlaufende zweite Flaschenrand der ersten Flasche führt dann zum Zeitpunkt $t_3$ wiederum zu einem Abfall des Empfangssignals.

Entsprechendes gilt für die Zeitpunkte $t_5$, $t_6$ und $t_7$ bzw. $t_9$, $t_{10}$ und $t_{11}$ für die zweite bzw. dritte Flasche, die nach der ersten Flasche in den Überwachungsbereich des Sensors bewegt werden.

Zu den Zeitpunkten $t_4$ und $t_8$ erfolgt ein starker Anstieg des Empfangssignals, da der Sensor zu diesem Zeitpunkt den zwischen der ersten und der zweiten bzw. der zweiten und der dritten Flasche bestehenden Zwischenraum "sieht". Wenn sich diese Zwischenräume im Überwachungsbereich befinden, kann der vom Sensor ausgesandte Lichtstrahl direkt zum Reflektor und von diesem zurück zum Sensor gelangen, ohne daß eine Abschwächung durch eine im Überwachungsbereich vorhandene Flasche erfolgt.

In Fig. 1 sind ebenso wie in den Fig. 2 - 4 insgesamt vier unterschiedliche Schalt-Schwellwerte $S_0$, $S_1$, $S_2$ und $S_3$ eingezeichnet. Der höchste Schalt-Schwellwert entspricht einer Amplitude, die geringfügig über derjenigen Amplitude liegt, die das Empfangssignal zu den Zeitpunkten $t_4$ und $t_8$ aufweist, wenn keine Abschwächung des in den Überwachungsbereich gesandten Lichts erfolgt. Die Amplitude des Schalt-Schwellwerts $S_2$ beträgt 92,5 % der Amplitude des Schalt-Schwellwerts $S_3$. Die Amplitude des Schalt-Schwellwertes $S_1$ beträgt 85 %, diejenige des Schalt-Schwellwertes $S_0$ 50 % der Amplitude des Schalt-Schwellwertes $S_3$. Diese prozentualen Verhältnisse gelten sowohl vor als auch nach einem erfindungsgemäßen Nachstellvorgang der Schalt-Schwellwerte, so daß es beispielsweise möglich ist, mittels eines Regelalgorithmus lediglich einen nachgestellten Schalt-Schwellwert $S_3$ zu berechnen und die Schalt-Schwellwerte $S_0$, $S_1$ und $S_2$ entsprechend den genannten Prozentsätzen zu berechnen.

In einem erfindungsgemäß arbeitenden Sensor wird für jeden Schalt-Schwellwert $S_0$, $S_1$, $S_2$ und $S_3$ jeweils ein Zähler $n_0$, $n_1$, $n_2$ und $n_3$ vorgesehen, welcher jeweils um 1 hochgezählt wird, wenn das Empfangssignal den entsprechenden Schwellwert überschreitet.

In dem in Fig. 1 gezeigten Beispiel werden die Schalt-Schwellwerte $S_0$, $S_1$ und $S_2$ jeweils viermal überschritten, während der Schalt-Schwellwert $S_3$ keinmal überschritten wird. Nach Empfang des Signals gemäß Fig. 1 würden also folgenden Zählerstände gelten:
$n_0 = 4$; $n_1 = 4$; $n_2 = 4$; $n_3 = 0$

Beim dargestellten Ausführungsbeispiel kann davon ausgegangen werden, daß die Schalt-Schwellwerte sowie der Erkennungs-Schwellwert, welcher gleich $S_1$ ist, korrekt eingestellt sind, wenn gilt:
$n_3 = 0$ und $n_1 = n_2$

Vorstehende Bedingung ist gemäß Fig. 1, wenn der zwischen den Zeitpunkten $t_1$ und $t_{11}$ verstrichene Zeitraum überwacht wird, erfüllt, so daß bei einem Empfangssignalverlauf gemäß Fig. 1 kein Nachstellen der Schalt-Schwellwerte bzw. des Erkennungs-Schwellwerts nötig ist. Gemäß Fig. 1 kann demzufolge immer dann, wenn der Erkennungs-Schwellwert $S_1$ vom Empfangssignal überschritten wird, davon ausgegangen werden, daß sich keine Flasche im Überwachungsbereich des Sensors befindet bzw. daß der Sensor gerade einen zwischen zwei aufeinanderfolgenden Flaschen bestehenden Zwischenraum "sieht".

Der Signalverlauf gemäß Fig. 2 unterscheidet sich vom Signalverlauf gemäß Fig. 1 dadurch, daß bei Erkennung der Zwischenräume auch der Schalt-Schwellwert $S_3$ überschritten wird. Die Zählerstände des Signals gemäß Fig. 2 sind daher wie folgt:
$n_0 = 4$; $n_1 = 4$; $n_2 = 4$; $n_3 = 4$

Die in Verbindung mit Fig. 1 bereits genannte Soll-Beziehung $n_3 = 0$ ist somit gemäß Fig. 2 nicht erfüllt, was bedeutet, daß die Schalt-Schwellwerte angehoben werden müssen. Die für die Anhebung der Schalt-Schwellwerte maßgebliche Regelabweichung e kann beispielsweise wie folgt berechnet werden:

_

$$e = (S_3 - S_2) \times n_3/n_2$$

Eine neue Schaltschwelle des $S_{3\,(neu)}$ kann dann folgendermaßen berechnet werden:
$S_{3\,(neu)} = S_{3\,(alt)}$ e K, wobei K einen konstanten Verstärkungsfaktor darstellt.

Die anderen Schalt-Schwellwerte bzw. der Erkennungs-Schwellwert können dann entsprechend den vorstehend bereits genannten Prozentsätzen eingestellt werden, wobei als Bezugsgröße der neu eingestellte Schalt-Schwellwert $S_{3\,(neu)}$ herangezogen wird.

Das beschriebene Anheben der Schalt-Schwellwerte in einer Betriebssituation gem. Fig. 2 erfolgt immer dann, wenn festgestellt wird, daß in einem vorgegebenen Betriebszeitraum ein Zählerstand $n_3 > 0$ auftritt.

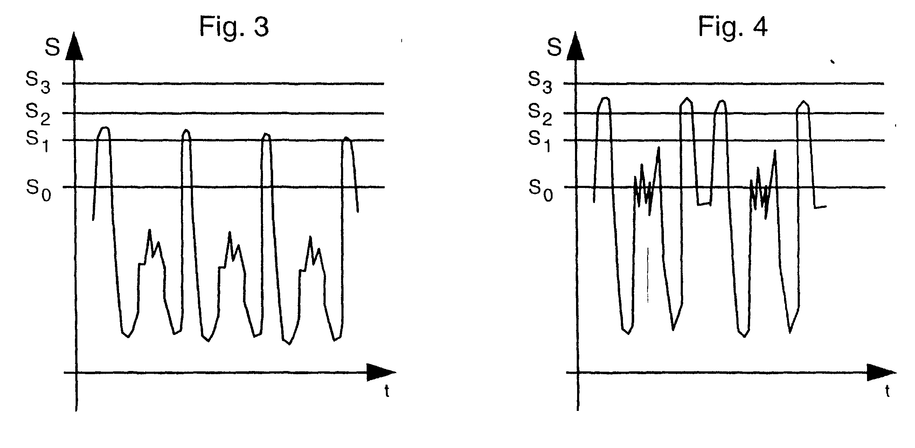

Bei einem Empfangs signal verlauf gemäß Fig. 3 ergibt sich folgender Zählerstand:
$n_0 = 4$; $n_1 = 4$; $n_2 = 0$; $n_3 = 0$

In diesem Fall ist also die Bedingung $n_1 = n_2$ nicht mehr erfüllt, da gilt $n_2 < n_1$. In diesem Fall müssen die Schalt-Schwellwerte bzw. der Erkennungs-Schwellwert abgesenkt werden.

Die Regelabweichung e für das Absenken kann sich in diesem Fall beispielsweise wie folgt berechnen:

$$e = -(S_2 - S_1) \times (n_1 - n_2)/n_1$$

Die Berechnung des neuen Schalt-Schwellwerts $S_{3\,(neu)}$ sowie der anderen neuen Schalt-Schwellwerte und des Erkennungs-Schwellwerts erfolgt analog zu dem Betriebsfall gemäß Fig. 2.

Die Empfindlichkeit des für das Anheben und Absenken der Schalt-Schwellwerte und des Erkennungs-Schwellwerts maßgeblichen Regelkreises gegenüber Störungen kann reduziert werden, indem ein kleiner Verstärkungsfaktor K eingestellt wird, indem die Regelabweichung e gefiltert wird oder indem ein I-Regler zum Einsatz kommt.

Im Zusammenhang mit Fig. 4 wird nachfolgend die Bedeutung des Schalt-Schwellwerts $S_0$ erläutert, welcher für das Anheben bzw. Absenken der Schalt-Schwellwerte gemäß der Fig. 2 und 3 nicht maßgeblich ist.

In dem in Fig. 4 dargestellten Ausführungsbeispiel beträgt der Schalt-Schwellwert $S_0$ 50 % des Schalt-Schwellwerts $S_3$. Der Schalt-Schwellwert $S_0$ wird für die Erzeugung einer Qualitätsaussage bezüglich des von einem erfindungsgemäß arbeitenden Sensors gelieferten Gegenstandsfeststellungssignals herangezogen. Bei dem in Fig. 4 gezeigten Betriebsfall werden folgende Zählerstände erhalten:
$n_0 = 12$; $n_1 = 4$; $n_2 = 4$; $n_3 = 0$

Immer wenn in einem vorgegebenen Betriebszeitraum der Zählerstand $n_0$ vom Zählerstand $n_1$ abweicht, was gemäß Fig. 4 der Fall ist, kann davon ausgegangen werden, daß die am Sensor vorbeilaufenden Flaschen das ausgesandte Licht nicht hinreichend gut abschwächen, so daß kein zuverlässiges Gegenstands-Feststellungssignal erzeugt werden kann. In dem

Fig. 4 gezeigten Betriebsfall schwächt der zwischen den Flaschenrändern liegende Bereich das ausgesandte Licht nicht hinreichend ab. In diesem Fall kann bei Nichterfüllung der Bedingung $n_0 = n_1$ ein Warnsignal abgegeben werden.

Falls beim erfindungsgemäßen Betrieb eines Sensors aufgrund besonderer Umstände ein automatisches Nachstellen nicht erfolgen kann, beispielsweise im Falle einer sprunghaften, verschmutzungsbedingten Signalreduzierung, kann manuell ein Initialisierungsprozeß ausgelöst werden, auf dessen Basis der weitere einwandfreie Betrieb des Sensors erfolgen kann.

Das erfindungsgemäße Verfahren ist nicht nur zur Klarglaserkennung einsetzbar, sondern kann beispielsweise immer dann zur Anwendung kommen, wenn Objekte erkannt werden sollen, welche das ausgesandte Licht lediglich abschwächen und einen Lichtempfang seitens des Sensors nicht vollständig verhindern. So können beispielsweise auch Objekte erkannt werden, die den Reflektor einer Reflex-Lichtschranke nur teilweise abdecken.

**Patentansprüche**

1. Verfahren zum Betrieb eines opto-elektronischen Sensors, insbesondere einer Lichtschranke, bei dem mittels eines Lichtsenders ein Lichtsignal in einen Überwachungsbereich gesandt wird und ein zum Empfang von ausgesandten und reflektieren Lichtsignalen ausgelegter Lichtempfänger ein Empfangssignal liefert, dessen Amplitude auf Vorhandensein eines Objekts im Überwachungsbereich untersucht wird, wobei bei Über- oder Unterschreitung eines Erkennungs-Schwellwerts ein Gegenstands-Feststellungssignal abgegeben wird,

   - wobei mehrere Schalt-Schwellwerte vorgegeben werden, wobei das Über- bzw. Unterschreiten dieser Schalt-Schwellwerte durch das Empfangssignal jeweils ein Schaltsignal auslöst,
   - wobei die Anzahl der bezüglich jedes Schalt-Schwellwerts auftretenden Schaltsignale ermittelt wird, und
   - wobei der Erkennungs-Schwellwert und die Schalt-Schwellwerte in Abhängigkeit von den ermittelten Anzahlen ein- oder nachgestellt werden.

2. Verfahren nach Anspruch 1,
   dadurch **gekennzeichnet**,

daß ein erster Schalt-Schwellwert der Amplitude des Empfangssignals bei objektfreiem Überwachungsbereich entspricht, wobei insbesondere alle anderen Schalt-Schwellwerte einem vorgegebenen Prozentsatz des ersten Schalt-Schwellwerts entsprechen, und/oder daß vor Inbetriebnahme des Sensors im Rahmen eines Initialisierungsprozesses bei objektfreiem Überwachungsbereich der erste Schalt-Schwellwert ermittelt und die anderen Schalt-Schwellwerte in Abhängigkeit von diesem Schalt-Schwellwert berechnet werden, wodurch alle Schalt-Schwellwerte an die während des Initialisierungsprozesses gegebenen Betriebsbedingungen angepaßt werden.

3. Verfahren nach einem der vorhergehenden Ansprüche,
dadurch **gekennzeichnet**,
daß die ermittelten und jeweils auf die Schalt-Schwellwerte bezogenen Anzahlen in Beziehung zueinander gesetzt und die jeweils gültigen Ist-Beziehungen mit vorgegebenen Soll-Beziehungen verglichen werden, wobei ein Nachstellen nur bei einer Abweichung der Ist-Beziehungen von den Soll-Beziehungen erfolgt, wobei insbesondere die Verhältnisse der Schalt-Schwellwerte zueinander konstant sind bzw. durch einen Nachstell-Vorgang nicht verändert werden, und/oder die auf die Schalt-Schwellwerte bezogenen Anzahlen jeweils für die Dauer einer vorgegebenen Betriebszeitspanne ermittelt werden, wobei ein Nachstellen am Ende der Betriebszeitspanne erfolgt und insbesondere während des Sensorbetriebs in einem konstanten Zeitraster wiederholt wird.

4. Verfahren nach einem der vorhergehenden Ansprüche,
dadurch **gekennzeichnet**,
daß insgesamt drei oder vier unterschiedliche Schalt-Schwellwerte vorgegeben werden, wobei insbesondere bei Vorsehung von drei Schalt-Schwellwerten $S_1$, $S_2$, $S_3$ gilt $S_3 > S_2 > S_1$, wobei $n_3$, $n_2$ und $n_1$ die jeweils innerhalb einer Betriebszeitspanne ermittelten Anzahlen der bezüglich jedes Schalt-Schwellwerts auftretenden Schaltsignale kennzeichnen.

5. Verfahren nach einem der Anspruch 4,
dadurch **gekennzeichnet**,
daß die vorgegebenen Soll-Beziehungen lauten:
$n_3 = 0$ und $n_1 = n_2$, und/oder daß die Schalt-Schwellwerte und der Erkennungs-Schwellwert angehoben werden, wenn gilt $n_3 > 0$, und/oder daß die Schalt-Schwellwerte und der Erkennungs-Schwellwert abgesenkt werden, wenn gilt $n_2 < n_1$.

6. Verfahren nach einem der Ansprüche 4 oder 5,
dadurch **gekennzeichnet**,

daß ein vierter Schalt-Schwellwert $S_0$ vorgegeben wird, für welchen gilt:
$S_1 > S_0$, wobei insbesondere ein Warnsignal erzeugt wird wenn $n_0$ von $n_1$ abweicht.

7. Verfahren nach einem der vorhergehenden Ansprüche,
dadurch **gekennzeichnet,**
daß einer der Schalt-Schwellwerte als Erkennungs-Schwellwert definiert wird.

8. Verfahren nach einem der Ansprüche 4, 5 oder 6,
dadurch **gekennzeichnet**,
daß der Schalt-Schwellwert $S_1$ als Erkennungs-Schwellwert definiert wird.

9. Verfahren nach einem der vorhergehenden Ansprüche,
dadurch **gekennzeichnet**,
daß der Lichtsender mit Pulslicht betrieben wird.

10. Verfahren nach einem der vorhergehenden Ansprüche,
dadurch **gekennzeichnet**,
daß bei Betrieb einer Reflex-Lichtschranke die ausgesandten Lichtsignale bei objektfreiem Überwachungsbereich von einem am dem Sensor gegenüberliegenden Ende des Überwachungsbereichs angeordneten Reflektor zum Lichtempfänger reflektiert werden.

11. Verwendung eines Verfahrens nach einem der vorhergehenden Ansprüche zur Klarglaserkennung.

**Claims**

1. A method of operating an optoelectronic sensor, in particular a light barrier, in which a light signal is sent by means of a light transmitter into a monitored region and a light receiver designed to receive transmitted and reflected light signals, delivers a reception signal, the amplitude of which is investigated for the presence of an object in the monitored region, with an article detection signal being transmitted if a recognition threshold is exceeded or fallen short of,

- wherein a plurality of switching threshold values are preset, with a switching signal being triggered when the received signal exceeds or falls short of these switching threshold values;
- wherein the number of the switching signals which arise with respect to each switching threshold is found; and
- wherein the recognition threshold value and the switching threshold values are set or adjusted in dependence on the numbers found.

**2.** A method in accordance with claim 1 characterized in that a first switching threshold value corresponds to the amplitude of the received signal when the monitored region is free of an object, with in particular all other switching threshold values corresponding to a preset percentage of the first switching threshold value, and/or in that prior to taking the sensor into operation in the context of an initialization process when the monitored region is free of an object, the first switching threshold value is found and the other switching threshold values are calculated in dependence on this switching threshold value, whereby all switching threshold values are matched to the operating conditions given during the initialization process.

**3.** A method in accordance with one of the preceding claims characterized in that the numbers found which respectively relate to the switching threshold values are set into relationship to one another and the respectively valid actual relationships are compared with predetermined desired relationships, with a readjustment only taking place when the actual relationships deviate from the desired relationships, with in particular the ratios of the switching threshold values relative to one another being constant, i.e. not being changed by a readjustment process; and/or in that the numbers related to the switching threshold values are respectively found for the duration of a predetermined operating time interval, at the end of which a readjustment takes place if required and is in particular repeated during the sensor operation in a constant time pattern.

**4.** A method in accordance with one of the preceding claims characterized in that a total of three or four different switching threshold values are preset and, in particular with the provision of three switching threshold values ($S_1$, $S_2$, $S_3$), the relationship $S_3 > S_2 > S_1$ applies, with $n_3$, $n_2$ and $n_1$ characterizing the numbers of the switching signals which respectively arise with respect to each switching threshold value within an operating time interval.

**5.** A method in accordance with claim 4 characterized in that the predetermined desired relationships are: $n_3 = 0$ and $n_1 = n_2$; and/or in that the switching threshold values and the recognition threshold value are increased when $n_3 > 0$ applies; and/or in that the switching threshold values and the recognition threshold value are lowered when $n_2 < n_1$ applies.

**6.** A method in accordance with claim 4 or claim 5 characterized in that a fourth switching threshold value $S_0$ is preset for which $S_1 > S_0$ applies, with in particular a warning signal being produced when $n_0$ deviates from $n_1$.

**7.** A method in accordance with one of the preceding claims characterized in that one of the switching threshold values is defined as a recognition threshold value.

**8.** A method in accordance with one of the claims 4, 5 or 6 characterized in that the switching threshold value $S_1$, is defined as a recognition threshold value.

**9.** A method in accordance with one of the preceding claims characterized in that the light transmitter is operated with pulsed light.

**10.** A method in accordance with one of the preceding claims characterized in that in the operation of a reflex light barrier, the transmitted light signals are reflected to the light receiver with an object-free monitored region from a reflector arranged at the end of the monitored region opposite to the sensor.

**11.** Use of a method in accordance with one of the preceding claims for the recognition of clear glass.

## Revendications

**1.** Procédé pour le fonctionnement d'un détecteur optoélectronique, en particulier d'une barrière lumineuse, dans lequel un signal lumineux émis au moyen d'un émetteur de lumière est envoyé dans une zone à surveiller, et un récepteur de lumière conçu pour recevoir des signaux lumineux émis et réfléchis délivre un signal de réception dont l'amplitude est analysée vis-à-vis de la présence d'un objet dans la zone à surveiller, et lorsque l'on passe au-dessus ou au-dessous d'une valeur de seuil de reconnaissance, un signal de constatation d'objet est émis ; procédé dans lequel :

-   on fixe plusieurs valeurs de seuil de commutation, un signal de commutation respectif étant déclenché lorsque le signal de réception passe au-dessus ou au-dessous de ces valeurs de seuil de commutation,
-   on détermine le nombre de signaux de commutation qui apparaissent en rapport avec chaque valeur de seuil de commutation, et
-   on règle ou on ajuste la valeur de seuil de reconnaissance et les valeurs de seuil de commutation en fonction des nombres déterminés.

**2.** Procédé selon la revendication 1, caractérisé en ce qu'une première valeur de seuil de commutation correspond à l'amplitude du signal de réception en l'absence d'objet dans la zone à surveiller, toutes les autres valeurs de seuil de commutation correspondant en particulier à un pourcentage prédéterminé de la première valeur de seuil de commutation, et/ou en ce qu'avant de mettre en service le détecteur, dans le cadre d'un processus d'initialisation en l'absence d'objet dans la zone à surveiller, on détermine la première valeur de seuil de commutation et on calcule les autres valeurs de seuil de commutation en fonction de cette première valeur de seuil de commutation, suite à quoi toutes les valeurs de seuil de commutation sont adaptées aux conditions de fonctionnement données pendant le processus d'initialisation.

3. Procédé selon l'une ou l'autre des revendications précédentes, caractérisé en ce que l'on met en relation les uns avec les autres les nombres déterminés et en rapport avec les valeurs de seuil de commutation respectives, et on compare les relations réelles respectives valables avec les relations de consigne données, procédé dans lequel un rajustement a lieu uniquement en cas d'écart entre les relations réelles et les relations de consigne, les relations des valeurs de seuil de commutation sont constantes les unes par rapport aux autres ou ne sont pas modifiées par une opération de rajustement, et/ou on détermine pour une période de fonctionnement respective prédéterminée les nombres en rapport avec les valeurs de seuil de commutation, on effectue un rajustement à la fin de la période de fonctionnement et on le répète en particulier pendant le fonctionnement du détecteur dans une grille temporelle constante.

4. Procédé selon l'une quelconque des revendications précédents, caractérisé en ce que l'on détermine au total trois ou quatre valeurs de seuil de commutation différentes, et en particulier lorsque l'on prévoit trois valeurs de seuil de commutation ($S_1$, $S_2$, $S_3$), s'applique $S_3 > S_2 > S_1$, $n_3$, $n_2$ et $n_1$ désignant les nombres détectés dans d'une période de fonctionnement des signaux de commutation apparaissant en rapport avec chaque valeur de seuil de commutation.

5. Procédé selon la revendication 4, caractérisé en ce que les relations de consigne prédéterminées sont les suivantes :
$n_3 = 0$ et $n_1 = n_2$, et/ou en ce que l'on augmente les valeurs de seuil de commutation et la valeur de seuil de reconnaissance lorsque $n_3 > 0$, et/ou en ce que l'on réduit les valeurs de seuil de commutation et la valeur de seuil de reconnaissance lorsque $n_2 < n_1$.

6. Procédé selon l'une ou l'autre des revendications 4 et 5, caractérisé en ce que l'on impose une quatrième valeur de seuil de commutation $S_0$ pour laquelle s'applique : $S_1 > S_0$,
un signal d'avertissement étant en particulier produit lorsque $n_0$ diffère de $n_1$.

7. Procédé selon l'une quelconque des revendications précédentes, caractérisé en ce que l'on définit l'une des valeurs de seuil de commutation à titre de valeur de seuil de reconnaissance.

8. Procédé selon l'une quelconque des revendications 4, 5 et 6, caractérisé en ce que l'on définit la valeur de seuil de commutation $S_1$ à titre de valeur de seuil de reconnaissance.

9. Procédé selon l'une quelconque des revendications précédentes, caractérisé en ce que l'émetteur de lumière fonctionne avec une lumière pulsée.

10. Procédé selon l'une quelconque des revendications précédentes, caractérisé en ce que lors du fonctionnement d'une barrière lumineuse à réflexion, les signaux lumineux émis en l'absence d'objet dans la zone à surveiller sont réfléchis vers le récepteur de lumière par un réflecteur disposé à l'extrémité, opposée au détecteur, de la zone à surveiller.

11. Application du procédé selon l'une quelconque des revendications précédentes pour la reconnaissance de verre clair.

Fig. 2

Fig. 1

Fig. 3

$S$

$S_3$

$S_2$
$S_1$

$S_0$

$t$

Fig. 4

$S$

$S_3$

$S_2$
$S_1$

$S_0$

$t$

EP 0 891 044 B1